# EUROPEAN PATENT APPLICATION

(11) **EP 1 988 407 A1**
(43) Date of publication of application: **05.11.2008**
(21) Application number: 07107340.7
(22) Date of filing: 02.05.2007
(51) Int. Cl.: G01S 5/14

(54) **Front-end circuit for satellite navigation system**

(71) Applicant: Septentrio N.V., 3001 Leuven (BE)
(72) Inventor: De Wilde, Wim, B-3010, KESSEL-LO (BE)
(74) Representative: Van Gysel, Stefan

(57) **Abstract**

The present invention is related to a receiver front-end circuit for a satellite navigation system comprising an input for a received signal, said received signal at least comprising a first satellite signal in a first satellite frequency band centred around a first frequency F1 and a second satellite signal in a second satellite frequency band centred around a second frequency F2, whereby the second satellite frequency band is adjacent to said first satellite frequency band. The receiver front-end circuit further comprises
- frequency shifting means for shifting the received signal such that the first frequency F1 is converted into a negative frequency and the second frequency F2 into a positive frequency and such that zero frequency falls between the converted first and second satellite frequency bands,
- first multiplication means for multiplying the frequency-shifted received signal with a first multiplication signal such that the multiplication means outputs the converted first satellite frequency band centred around zero frequency, and
- second multiplication means for multiplying the frequency-shifted received signal with a second multiplication signal derived from the first multiplication signal such that the multiplication means outputs the converted second satellite frequency band centred around zero frequency.

## Description

### Field of the invention

The present invention relates to a front-end circuit for use in a global navigation satellite system.

### State of the art

Global Navigation Satellite System (GNSS) is a general name for a satellite navigation system. All systems of this kind are frequently called 'GPS', although GPS specifically describes the American system. The systems built so far work according to the same principle: the signal from at least four satellites is evaluated and the receiver computes its position.

At present there are two operational systems: GPS and its Russian counterpart, Glonass. In a couple of years the European system, called Galileo will get operational.

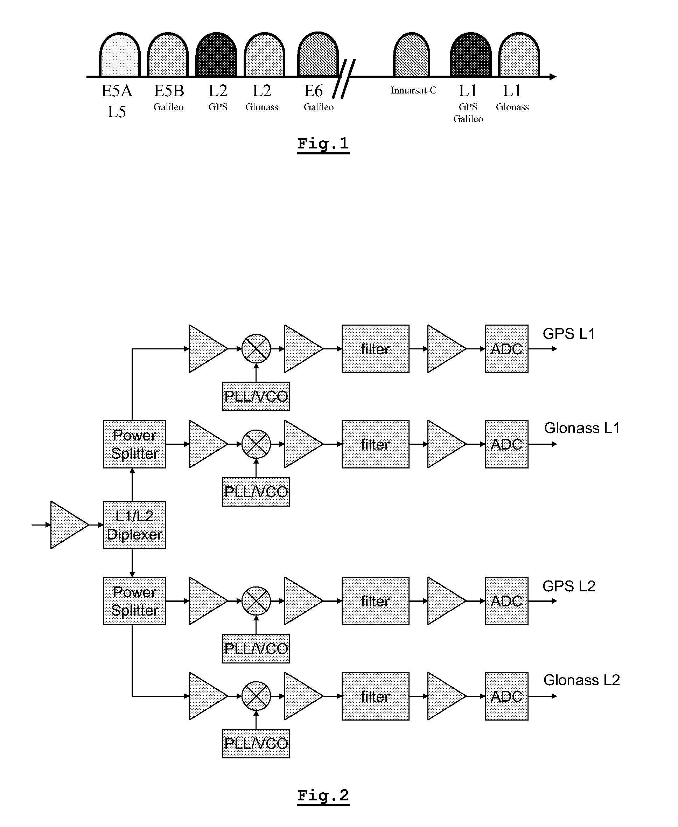

All of these systems transmit signals at at least two centre frequencies in the L-band. The precise frequencies and system bandwidths are listed in Table 1 below. The Inmarsat augmentation system is included as well.
Generally the frequencies can be partitioned in frequencies around 1.2 GHz and frequencies around 1.6 GHz. Fig. 1 visualises the frequency band positions.

**Table 1**

| **System** | **Band Name** | **Centre Freq. (MHz)** | **Full System BW (MHz)** |
|---|---|---|---|
| GPS | L1 | 1575.42 | 20 |
| GPS | L2 | 1227.6 | 20 |
| GPS | L5 | 1176.45 | 20 |
| Glonass | L1 | 1603.4 | 21 |
| Glonass | L2 | 1247.1 | 18.5 |
| Galileo | L1 | 1575.42 | 40 |
| Galileo | E6 | 1278.75 | 40 |
| Galileo | E5B | 1207.14 | 20 |
| Galileo | E5A | 1176.45 | 20 |
| Inmarsat | C downlink | 1237.5 | 15 |

In many of the bands multiple signal types are transmitted in overlay to each other, often with different bandwidth (e.g. BPSK at 1 MHz and BPSK at 10 MHz). This in combination with the multitude of frequencies opens the door to a large variety of receivers.

The market demand for receivers that support multiple systems is increasing. This often implies the use of multiple frequency bands. A typical block diagram of a multi-band front-end is in Fig.2. Each band is received through a separate front-end circuit comprising a separate down-converting mixer, filter, gain blocks and ADC. Several architectures exist for the front-end channel. Traditionally heterodyning receivers were very popular in GPS, in which the input frequency is multiplied with a frequency that is significantly lower or higher. In this way the signal is shifted to the difference frequency. This is filtered and further converted into a baseband signal before or after digitization. Another architecture that recently has gained popularity is direct conversion, in which the input signal is multiplied by a sine wave at its centre frequency. In this way the signal is immediately shifted to the base-band and digitized by a two-channel ADC for further processing.

Each additional front-end circuit takes a considerable amount board area and power, which leads to a design of both increased cost and size.

Hence, there is a need for a front-end circuit of reduced complexity that supports multiple satellite navigation systems.

### Aims of the invention

The present invention aims to provide a front-end circuit for a satellite navigation system that overcomes the problems of the prior art solutions.

### Summary of the invention

The present invention relates to a receiver front-end circuit for a satellite navigation system comprising an input for a received signal, said received signal at least comprising a first satellite signal in a first satellite frequency band centred around a first frequency F1 and a second satellite signal in a second satellite frequency band centred around a second frequency F2, whereby the second satellite frequency band is adjacent to the first satellite frequency band. The receiver front-end circuit further comprises
- frequency shifting means for shifting the received signal in frequency such that the first frequency F1 is converted into a negative frequency and the second frequency F2 into a positive frequency and such that zero frequency falls between said converted first and second satellite frequency bands,
- first multiplication means for multiplying the frequency-shifted received signal with a first multiplication signal such that the multiplication means outputs the converted first satellite frequency band centred around zero frequency, and
- second multiplication means for multiplying the frequency-shifted received signal with a second multiplication signal derived from the first multiplication signal such that the multiplication means outputs the converted second satellite frequency band centred around zero frequency.

In a preferred embodiment the receiver further comprises an A/D converter coupled with the frequency shifting means for digitizing the frequency-shifted received signal. The A/D converter is then preferably a two-channel A/D converter for simultaneous conversion of the in-phase and quadrature components. The first multiplication signal is then preferably a complex digital sine wave. The second multiplication signal is then the conjugate of that complex digital sine wave.

Advantageously the receiver front-end circuit further comprises an anti-aliasing filter coupled with the input of the A/D converter.

In another embodiment the front-end circuit also comprises a first decimator filter coupled with the first multiplication means' output and a second decimator filter coupled with the second multiplication means' output.

In an advantageous embodiment the frequency shifting means is arranged for shifting the received signal in frequency over (F1+F2)/2. The digital sine wave is preferably at frequency (F2-F1)/2.

In a more specific embodiment the first satellite frequency band is the GPS L1 band and the second satellite frequency band is the GLONASS L1 band. Other band combinations to which the front-end circuit of the present invention advantageously can be applied are GPS L2 + GLONASS L2, Galileo E5B + GPS L2, Galileo E5A + Galileo E5B. Other combinations however can be envisaged as well.

In a second aspect the invention relates to a satellite navigation system comprising a receiver front-end circuit as previously described.

### Short description of the drawings

Fig. 1 represents the position of various satellite frequency bands on a frequency axis.

Fig. 2 represents a prior art multi-band front-end.

Fig. 3 represents a front-end according to the present invention.

Fig. 4 represents the generation of a digital sine wave.

Fig. 5 represents the expansion to a four-band front-end circuit.

### Detailed description of the invention

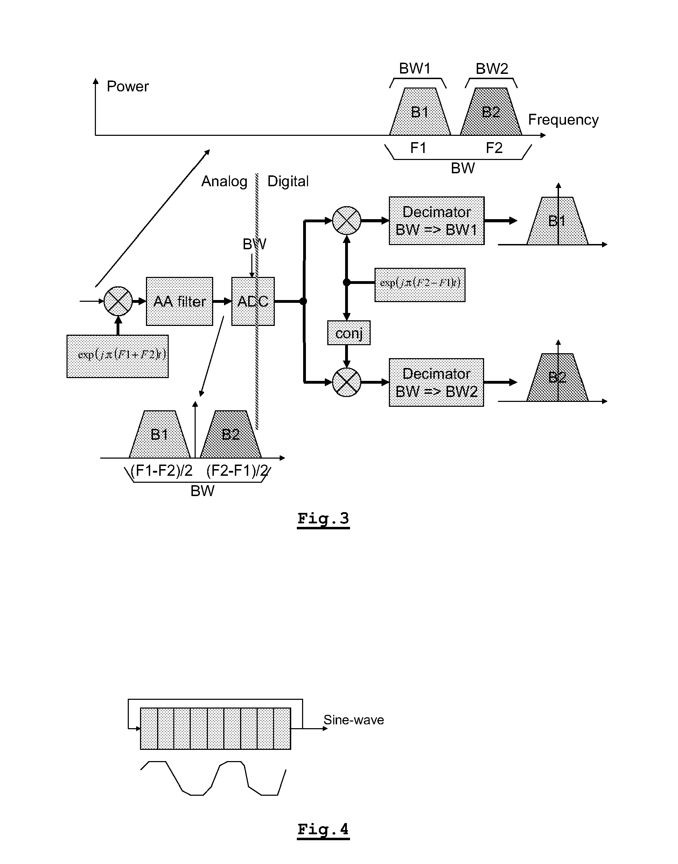

The present invention proposes a front-end capable of down-converting two adjacent frequency bands simultaneously. Its architecture is shown in Fig.3. The input signal consists of two GNSS bands, one at centre frequency F1 with bandwidth BW1, the other one at F2 with bandwidth BW2. The total signal bandwidth is BW. B1 could for instance be the GPS L1 band and B2 the Glonass L1 band.

The signal is first multiplied by a complex sine wave at the average frequency. In this way it is converted in a complex signal with one band at a negative frequency -(F2-F1)/2 and the other band at the opposite positive frequency. This signal is filtered, amplified and preferably digitized by a two-channel ADC that is running at a speed BW. So basically the front-end can be considered as a direct conversion front-end operating at the average frequency of the targeted input signal.

All further processing is then preferably done in the digital chip. The digital signal is split in two branches. In the first branch it is multiplied by a complex sine-wave at a frequency of (F2-F1)/2. This sine-wave can be generated by means of a look-up table as will be explained below. The output signal of the multiplier consists of the B1 signal centre around the origin and B2 on top of it. B2 is removed by a filter at a double-sided bandwidth of BW1 and decimated to a rate of BW1 for further base-band processing. In the other branch the signal is multiplied by a complex sine-wave at the opposite frequency (i.e. -(F2-F1)/2). This is derived by just reversing the imaginary component of the sine-wave in the first branch (complex conjugation). Alternatively, the complex conjugation could also be done at the digital input signal. The resulting signal is filtered and decimated to BW2 to yield the B2 baseband signal.

The digital sine-wave generation can advantageously be done in the following very simple way. Usually there is some freedom on BW and the effective F1 and F2. It is sufficient to work with approximate frequencies rather than exact frequencies, since the baseband circuitry can easily compensate for some offset. Now BW should be chosen such that it is in a (irreducible) rational ratio M/N to (F2-F1)/2. In this way there are M periods of the sampling clock (BW) in N periods of (F2-Fl)/2. The N samples of the complex sine-wave should now be stored in a look-up table (or FIFO) that is periodically read on the sampling clock. This avoids any numerically-controlled oscillators or complex sine-wave tables. The FIFO-implementation is illustrated in Fig.4.

The present invention offers several advantages. A 50 MHz front-end takes exactly the same board area as a 20 MHz front-end if similar component technologies are used. The area taken by the digital implementation is negligible compared to the rest of the digital chip. So effectively the needed board area is halved. Power consumption reduces, since it scales much less than proportional as function of the bandwidth. The digital power consumption is very low compared to front-end power when the digital part is implemented in a modern technology (90 nm FPGA or 0.18µ ASIC).

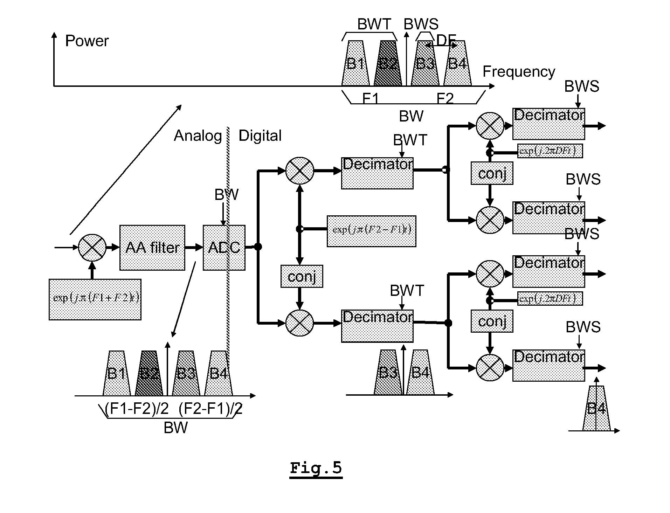

The invention can easily be expanded to a four-band front-end as well. First the two lowest and two highest bands are conceived as two single bands and processed as in the previously described embodiment. The two baseband outputs each contain two actual bands, one at negative frequency and one at positive frequency, as in the original situation. Hence, these two bands can be separated by a cascaded dual band down-converter with exactly the same architecture as the original one. This is further clarified in Fig.5. More specifically this concept advantageously applies to a simultaneous down-conversion of the following frequency band combinations : GPS L2 + GLONASS L2, Galileo E5B + GPS L2, Galileo E5A + Galileo E5B.

## Claims

1. Receiver front-end circuit for a satellite navigation system comprising an input for a received signal, said received signal at least comprising a first satellite signal in a first satellite frequency band centred around a first frequency F1 and a second satellite signal in a second satellite frequency band centred around a second frequency F2, said second satellite frequency band being adjacent to said first satellite frequency band, said receiver front-end circuit further comprising
- frequency shifting means for shifting said received signal in frequency such that said first frequency F1 is converted into a negative frequency and said second frequency F2 into a positive frequency and such that zero frequency falls between said converted first and second satellite frequency bands,
- first multiplication means for multiplying said frequency-shifted received signal with a first multiplication signal such that said multiplication means outputs said converted first satellite frequency band centred around zero frequency, and
- second multiplication means for multiplying said frequency-shifted received signal with a second multiplication signal derived from said first multiplication signal such that said multiplication means outputs said converted second satellite frequency band centred around zero frequency.

2. Receiver front-end circuit as in claim 1, further comprising an A/D converter coupled with said frequency shifting means for digitizing said frequency-shifted received signal.

3. Receiver front-end circuit as in claim 2, wherein said first multiplication signal is a complex digital sine wave and said second multiplication signal is the conjugate of said complex digital sine wave.

4. Receiver front-end circuit as in claim 3, further comprising a digital sine wave generator for generating said digital sine wave.

5. Receiver front-end circuit as in any of claims 2 to 4, further comprising an anti-aliasing filter coupled with the input of said A/D converter.

6. Receiver front-end circuit as in any of claims 1 to 5, further comprising a first decimator filter coupled with said first multiplication means' output and a second decimator filter coupled with said second multiplication means' output.

7. Receiver front-end circuit as in any of claims 1 to 6, wherein said frequency shifting means is arranged for shifting said received signal in frequency over (F1+F2) /2.

8. Receiver front-end circuit as in any claims 3 or 4, wherein said digital sine wave is at frequency (F2-F1)/2.

9. Receiver front-end circuit as in any of the previous claims, wherein said first satellite frequency band is the GPS L1 band and said second satellite frequency band is the GLONASS L1 band.

10. Satellite navigation system comprising a receiver front-end circuit as in any of claims 1 to 9.
